# EUROPEAN PATENT APPLICATION

(11) **EP 4 808 330 A1**
(43) Date of publication of application: **16.09.2026**
(21) Application number: 26162551.1
(22) Date of filing: 05.03.2026
(51) Int. Cl.: H10K 59/80, H10K 50/19

(54) **LIGHT EMITTING DISPLAY APPARATUS**

(30) Priority: 14.03.2025 KR 20250033570; 30.06.2025 KR 20250086598
(71) Applicant: LG Display Co., Ltd., Seoul, 07336 (KR)
(72) Inventor: LIM, YoungNam, 10845 Paju-si, Gyeonggi-do (KR); NAM, SeoHyun, 10845 Paju-si, Gyeonggi-do (KR); JUNG, HyeSun, 10845 Paju-si, Gyeonggi-do (KR)
(74) Representative: Viering, Jentschura & Partner mbB Patent- und Rechtsanwälte

(57) **Abstract**

A light emitting display apparatus including a light emitting device layer (EDL) configured on a substrate (100) and including a first electrode (E1), an emission part (EP), and a second electrode (E2); a scattering layer (160) configured on the second electrode (E2); and a protective layer (170) configured on the scattering layer (160) is provided. The scattering layer (160) scatters emitted light, improving luminance viewing angle characteristics and light extraction. Improved light extraction allows for lower power consumption to achieve a desired luminance.

## Description

### BACKGROUND

### FIELD

Embodiments of the invention relate generally to a light emitting display apparatus.

### DISCUSSION OF THE BACKGROUND

Light emitting display apparatuses are being widely used as display screens of various products and portable electronic devices such as smartphones and personal computers (PCs), wearable devices such as smartwatches, televisions (TVs), notebook computers and monitors. For example, display apparatuses include a display panel including a plurality of pixels which collectively display an image, based on the emission of light by a light emitting device.

Light emitting display apparatuses display an image through the emission of light by an emission part disposed between two electrodes (for example, an anode electrode and a cathode electrode) for each of a plurality of light emitting components known as pixels. In the relevant art, pixels have been constructed to emit light and thus present an image in a direction that is generally perpendicular to the plane of a planar display apparatus. However, in many situations, consumers find a display to be more valuable if they can view and properly perceive an image from angles shallower than this perpendicular. An improved display device would allow an image to be viewed from an improved range of angles without distortion or color washout. There is a need in the art for improved light emitting display devices that would offer better economy and find use in a variety of consumer electronics and military and industrial equipment, particularly in such specialty areas as virtual reality headsets or automotive dashboard displays.

The above information disclosed in this Background section is only for understanding of the background of the inventive concepts, and, therefore, it may contain information that does not constitute prior art.

### SUMMARY

In organic light emitting display apparatuses having a microcavity structure, each of a plurality of sub-pixels may have a structure and a thickness based on a designed microcavity size, which is related to a distance between two electrodes and, in turn, to a wavelength of light emitted from an emission part. Researchers have experimented with varying the microcavity size in order to enhance the efficiency of light extraction.

However, there are tradeoffs. For example, an intensity of light emitted from each sub-pixel may increase based on a modified microcavity effect, but a viewing angle characteristic of the light emitting display apparatus may be correspondingly degraded. For example, based on a strong microcavity structure by a cathode electrode and a plurality of capping layers, light emitted from each of the plurality of sub-pixels may concentrate in a direction perpendicular to the capping layer surface, and, consequently, the luminance viewing angle of the emitted light may be narrow, and the amount of light extraction may be small.

The present inventors have recognized the problem and have invented a light emitting display apparatus having an enhanced luminance viewing angle characteristic with improved light extraction.

One object of the present disclosure is to provide a light emitting display apparatus having an enhanced luminance viewing angle characteristic.

Another object of the present disclosure is to provide a light emitting display apparatus with both an enhanced luminance viewing angle characteristic and an increased amount of light extraction.

Another object of the present disclosure is to provide a light emitting display apparatus having reduced power consumption through low power driving made possible by an increase in the amount of light extraction.

Additional features of the inventive concepts will be set forth in the description which follows, and in part will be apparent from the description, or may be learned by practice of the inventive concepts. According to an aspect of the present disclosure, a light emitting display apparatus according to claim 1 is provided. Further embodiments are described in the dependent claims.

A light emitting display apparatus according to an embodiment includes a light emitting device layer configured on a substrate and may include a first electrode, an emission part, and a second electrode; a scattering layer configured on the second electrode; and a protective layer configured on the scattering layer.

In the light emitting display apparatus, the scattering layer may be made of a material capable of having unevenness or irregular unevenness due to an intermolecular stack structure.

Each molecule of the scattering layer may have a diameter of 10Å to 25Å.

The scattering layer may be made of an organic material.

The scattering layer may include a light scattering surface.

The scattering layer may include a tetraphenylethylene-based molecular structure.

A molecular weight of the scattering layer may be 500 or less.

The scattering layer may be made of an organic material including a plurality of aromatic rings and a double bond structure, and two or more of the plurality of aromatic rings may be in a rotated conformation such that the double bond structure is not coplanar with the aromatic rings.

The scattering layer may comprise one of bathocuproine, triphenylamine derivatives, bathophenanthroline, perylene derivatives, and pentacene derivatives.

The scattering layer may have a thickness of 500Å to 3000Å.

A surface roughness of the light scattering surface may be 10 nm or more.

The second electrode may be made of a transparent conductive oxide or an alloy material of silver (Ag) and magnesium (Mg), and the second electrode made of the transparent conductive oxide may include a surface-modified layer surface-treated by oxygen plasma.

The light emitting display apparatus may further comprise a functional intermediate layer disposed between the second electrode and the scattering layer.

The functional intermediate layer may include a capping layer made of an organic material, and the capping layer may include a surface-modified layer surface-treated by oxygen plasma.

The functional intermediate layer may include a first capping layer and a second capping layer having different refractive indices, the first capping layer may be in contact with the second electrode, and the second capping layer may be disposed between the first capping layer and the scattering layer and may include one of LiF, MgF₂, AlF₃, NaF, and AlOₓ.

The second capping layer, which is in contact with the scattering layer, may include a surface-modified layer surface-treated by oxygen plasma.

The functional intermediate layer may further include a third capping layer on the second capping layer, and the scattering layer may be on the third capping layer.

The third capping layer may include AgYb.

The third capping layer, which is in contact with the scattering layer may include a surface-modified layer surface-treated by oxygen plasma.

The emission part may include one or more emission layers between the first electrode and the second electrode.

The light emitting display device may be flexible.

A light emitting display apparatus according to another embodiment includes a light emitting device layer disposed on a substrate and including a first electrode, an emission part, and a second electrode; a surface-modified layer disposed on the emission part, the surface-modified layer having a first surface roughness resulting from an oxygen plasma treatment; and a scattering layer contacting the surface-modified layer; in which the scattering layer has a light scattering surface with a second surface roughness that is greater than the first surface roughness.

The second electrode may comprise the surface-modified layer.

A light emitting display apparatus according to another embodiment may comprise a light emitting device layer disposed on a substrate and including a first electrode, an emission part, and a second electrode, and a light scattering layer disposed on the emission part, the light scattering layer having an irregular rough light scattering surface, wherein the light scattering layer may be formed by deposition of an organic compound, the deposition of the organic compound may form an intermolecular stacking structure, the organic compound may comprise a core structure having 24 carbon atoms or less, wherein all carbon atoms of the core structure are in the same plane, the organic compound may further comprise at least two substituent groups, wherein the organic compound may assume conformations in which at least portions of the substituent groups are not found in the plane of the core structure, and the substituent groups may be selected from the group consisting of phenyl groups, substituted or unsubstituted, and aliphatic hydrocarbon chains, branched or unbranched, having at least ten carbon atoms.

The second electrode may be interposed between the emission part and the light scattering layer.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a diagram for describing a light emitting display apparatus according to an embodiment of the present disclosure.
FIG. 2 is an equivalent circuit diagram illustrating an example of a configuration of one sub-pixel in a light emitting display apparatus according to an embodiment of the present disclosure.
FIG. 3 is a cross-sectional view illustrating an example of a structure of one sub-pixel also illustrated in FIGS. 1 and 2.
FIG. 4 is an enlarged view of a portion A illustrated in FIG. 3.
FIG. 5 is another enlarged view of a portion A illustrated in FIG. 3.
FIG. 6 is another enlarged view of a portion A illustrated in FIG. 3.
FIG. 7 is another enlarged view of a portion A illustrated in FIG. 3.
FIG. 8 is another cross-sectional view illustrating an example of a structure of one sub-pixel also illustrated in FIGS. 1 and 2.
FIG. 9 is another cross-sectional view illustrating an example of a structure of one sub-pixel also illustrated in FIGS. 1 and 2.
FIG. 10 is another cross-sectional view illustrating an example of a structure of one sub-pixel also illustrated in FIGS. 1 and 2.
FIG. 11 is a diagram illustrating how roughness of a light scattering surface varies with respect to a thickness of a scattering layer in a light emitting display apparatus according to an embodiment of the present disclosure.
FIG. 12 is a view illustrating how luminance viewing angles vary with respect to roughness of a scattering layer in a light emitting display apparatus according to an embodiment of the present disclosure.
FIG. 13 is a view illustrating luminance with respect to viewing angles of a light emitting display apparatus including a scattering layer according to an embodiment of the present disclosure (solid line) and luminance with respect to viewing angles of a light emitting display apparatus without a scattering layer according to an experimental example (dotted line).

Throughout the drawings and the detailed description, unless otherwise described, the same drawing reference numerals should be understood to refer to the same elements, features, and structures. The sizes, lengths, and thicknesses of layers, regions, and elements, and depiction thereof may be exaggerated for clarity, illustration, and/or convenience.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

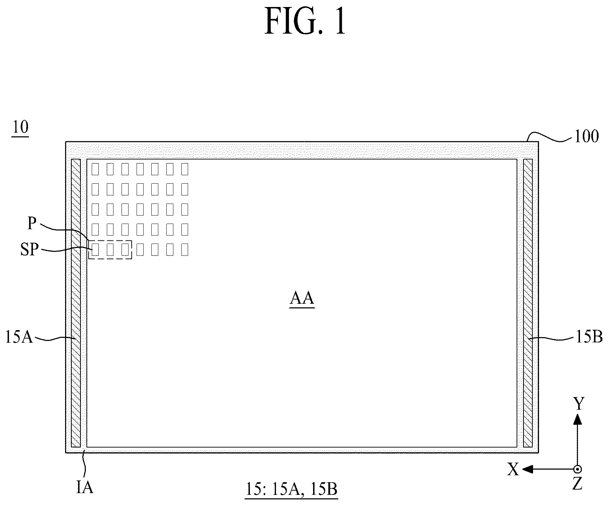

FIG. 1 is a diagram for describing a light emitting display apparatus according to an embodiment of the present disclosure.

Referring to FIG. 1, the light emitting display apparatus according to an embodiment of the present disclosure may include a display panel 10.

The display panel 10 may include a plurality of pixels P which are disposed on a substrate 100.

The substrate 100 may be made of a plastic material or a glass material. For example, the substrate 100 may include one or more plastic material layers, but is not limited thereto. The substrate 100 may include a display area AA and a non-display area IA.

The display area AA may be an area which displays an image and may be a pixel array area, an active area, a pixel array part, a display part, or a screen. The display area AA may include the plurality of pixels P.

The plurality of pixels P may be disposed in the display area AA to display an image.

The plurality of pixels P may be arranged (or configured) along a first direction X (or a horizontal line) and a second direction Y (or a vertical line) intersecting with the first direction X. Each of the plurality of pixels P may be a unit pixel (or a unit area), which displays a real image. Each of the plurality of pixels P may include a plurality of adjacent sub-pixels SP.

At least three adjacent sub-pixels SP among a plurality of sub-pixels SP may configure one pixel (or unit pixel) P, which implements a color image. For example, one pixel P may include first to third sub-pixels SP, which emit lights of different colors. For example, the first sub-pixel SP may be a red sub-pixel, which emits red light, the second sub-pixel SP may be a green sub-pixel, which emits green light, the third sub-pixel SP may be a blue sub-pixel, which emits blue light, but is not limited thereto. For example, one pixel P may further include a white sub-pixel, which emits white light.

Each of the plurality of sub-pixels SP may be disposed (or configured) to be connected to a pixel driving line and may be configured to emit light based on a signal supplied from the pixel driving line. Each of the plurality of sub-pixels SP may be configured to be electrically connected to the pixel driving line, which includes a gate line, a data line, and a pixel driving power line. Each of the plurality of sub-pixels SP may include a light emitting device for displaying an image and a pixel circuit including a plurality of thin-film transistors connected to the pixel driving line to independently drive the light emitting device.

The plurality of sub-pixels SP may be disposed to have a planar structure of an RGB stripe type or an RGBW stripe type, but are not limited thereto. For example, the plurality of sub-pixels SP may be disposed to have a planar structure of a pentile type.

The non-display area IA may be an area which does not display an image and may be a peripheral circuit area, a signal supply area, an inactive area, or a bezel area. The non-display area IA may be configured to surround the display area AA.

The display panel 10 or the substrate 100 may further include a peripheral circuit unit 15 disposed in the non-display area IA. The peripheral circuit unit 15 may include gate driving circuits 15A and 15B connected to the plurality of sub-pixels SP.

The gate driving circuits 15A and 15B may be disposed in the non-display area IA of the substrate 100 and may be configured to drive a plurality of gate lines disposed in the display area AA. The gate driving circuit may be configured to drive the plurality of gate lines in response to a gate driving control signal including a gate driving voltage supplied through a gate driving voltage line and a plurality of clock signals supplied through a plurality of clock signal lines, or the like.

The gate driving circuits 15A and 15B may be directly formed or implemented on the substrate 100 by a manufacturing process providing a thin-film transistor for each pixel, based on a gate in panel (GIP) type. For example, the gate driving circuits 15A and 15B may be an embedded gate circuit or a gate shift register circuit, but are not limited thereto.

The gate driving circuits 15A and 15B may include one or more of a first gate driving circuit 15A and a second gate driving circuit 15B.

The first gate driving circuit 15A may be implemented in the non-display area IA adjacent to a first side (or one side) of the display area AA. The second gate driving circuit 15B may be implemented in the non-display area IA adjacent to a second side (or the other side) opposite to the first side of the display area AA. The gate driving circuits 15A and 15B may be configured to supply a first scan signal, a second scan signal, a first emission control signal, and a second emission control signal to the plurality of sub-pixels SP, but are not limited thereto. For example, the signals supplied from the gate driving circuits 15A and 15B to the sub-pixel SP may correspond to a configuration (or a structure) of the pixel circuit.

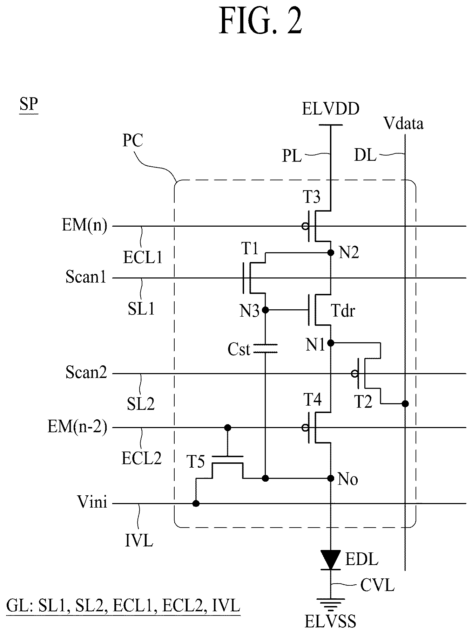

FIG. 2 is an equivalent circuit diagram illustrating an example of a configuration of one sub-pixel SP in a light emitting display apparatus according to an embodiment of the present disclosure.

Referring to FIGS. 1 and 2, the sub-pixel SP according to an embodiment of the present disclosure may include a pixel circuit PC and a light emitting device layer EDL.

The pixel circuit PC according to an embodiment of the present disclosure may include a switching transistor T2 configured to output a data voltage Vdata supplied through the data line DL, and a driving transistor Tdr which is turned on based on gate-source voltages thereof (or a voltage between the gate and the source) and configured to output a data current corresponding to the data voltage supplied from the switching transistor T2 to the light emitting element layer EDL. The pixel circuit PC according to an embodiment of the present disclosure may further include a light emission control transistor T4 connected between the light emitting device layer EDL and the driving transistor Tdr.

The pixel circuit PC according to another embodiment of the present disclosure may include a driving thin-film transistor Tdr, first to fifth thin-film transistors T1 to T5, and a storage capacitor Cst.

Each of the thin-film transistors Tdr and T1 to T5 may be a thin-film transistor and may be any one of a polysilicon semiconductor, an amorphous silicon semiconductor, or an oxide semiconductor. For example, the oxide semiconductor may include a metal oxide such as indium-gallium-zinc-oxide (IGZO).

Thin-film transistors Tdr and T1 to T5 configuring the pixel circuit PC may be configured as same or different thin-film transistors selected from an oxide thin-film transistor and an LTPS (low-temperature polycrystalline silicon) thin-film transistor. Thin-film transistors Tdr and T1 to T5 configuring the pixel circuit PC may be configured as same or different types of thin-film transistors selected from P-type and N-type.

In the pixel circuit PC, the second, third, and fourth thin-film transistors T2, T3, and T4 may be configured as high mobility P-type LTPS transistors, and the driving thin-film transistor Tdr, the first thin-film transistor T1, and the fifth thin-film transistor T5 may be configured as N-type oxide thin-film transistors with lower off-current (or leakage current) than the LTPS thin-film transistors, but are not limited thereto.

Thin-film transistors Tdr and T1 to T5 configuring the pixel circuit PC may be 3-electrode devices including a gate electrode, a source electrode, and a drain electrode. Since the source electrode and the drain electrode are not fixed and may be changed based on a voltage and a current direction applied to the gate electrode (or a control electrode), either the source electrode or the drain electrode may be a first electrode (or an input electrode), and the other one may be a second electrode (or an output electrode).

The sub-pixel SP may be driven in an initial period, a sampling period, and an emission period in each frame, but is not limited thereto.

The first thin-film transistor T1 may be controlled by a first scan line SL1 of the gate line GL and may be configured to connect a third node N3 which is connected to a gate electrode of the driving thin-film transistor Tdr and a second node N2 which is connected to a drain electrode of the driving thin-film transistor Tdr. The first thin-film transistor T1 may be configured to connect the gate electrode and the drain electrode of the driving thin-film transistor Tdr during the initialization period and the sampling period in response to the first scan signal Scan1 from the first scan line SL1, thereby connecting the driving thin-film transistor Tdr in a diode connection structure. For example, the first thin-film transistor T1 may be a sampling transistor, but is not limited thereto.

The second thin-film transistor T2 may be controlled by a second scan line SL2 of the gate line GL and may be configured to connect a first node N1 which is connected to a source electrode of the driving thin-film transistor Tdr and the data line DL. The second thin-film transistor T2 may be configured to apply the data voltage Vdata supplied through the data line DL to the driving thin-film transistor Tdr during the sampling period in response to the second scan signal Scan2 from the second scan line SL2. For example, the second thin-film transistor T2 may be a switching transistor, but is not limited thereto.

The third thin-film transistor T3 may be controlled by a first emission control line ECL1 of the gate line GL and may be configured to connect the second node N2 which is connected to the drain electrode of the driving thin-film transistor Tdr and a pixel driving voltage line PL. The third thin-film transistor T3 may be configured to apply a pixel driving voltage ELVDD supplied through the pixel driving voltage line PL to the driving thin-film transistor Tdr during the initialization period and the emission period in response to a first emission control signal EM(n) supplied through the first emission control line ECL1. For example, the third thin-film transistor T3 may be an operation control transistor, but is not limited thereto.

The fourth thin-film transistor T4 may be controlled by a second emission control line ECL2 of the gate line GL and may be configured to connect the first node N1 which is connected to the source electrode of the driving thin-film transistor Tdr and an output node No which is connected to the light emitting device layer EDL. The fourth thin-film transistor T4 may be configured to connect the driving thin-film transistor Tdr to the light emitting device layer EDL during the emission period in response to a second emission control signal EM(n-2) supplied through the second emission control line ECL2. For example, the fourth thin-film transistor T4 may be an emission control transistor, but is not limited thereto.

The fifth thin-film transistor T5 may be controlled by the second emission control line ECL2 of the gate line GL and may be configured to connect an initialization voltage line IVL and the output node No which is connected to the light emitting device layer EDL. The fifth thin-film transistor T5 may be configured to apply an initialization voltage Vini supplied from the initialization voltage line IVL to the light emitting device layer EDL during the initialization period and the sampling period except for the emission period in response to a second emission control signal EM(n-2) supplied through the second emission control line ECL2. The initialization voltage Vini may be expressed as a reference voltage. The fifth thin-film transistor T5 may be configured to operate oppositely to the fourth thin-film transistor T4 based on the second emission control signal EM(n-2). For example, the fifth thin-film transistor T5 may be an initialization transistor, but is not limited thereto. For example, the fourth thin-film transistor T4 and the fifth thin-film transistor T5 share the second emission control signal EM(n-2), and thus, a size of the gate driving circuit may be reduced in the light emitting display apparatus.

The storage capacitor Cst may be configured to be connected between the third node N3 and the output node No and may be charged with and hold a target voltage corresponding to a differential voltage (Vdata + Vth - Vini) between the data voltage Vdata which is compensated for a threshold voltage Vth of the driving thin-film transistor Tdr and the initialization voltage Vini during the sampling period, and may be configured to apply the held target voltage to the driving thin-film transistor Tdr during the emission period.

The driving thin-film transistor Tdr may include the gate electrode connected to the third node N3, the source electrode connected to the first node N1, and a drain electrode connected to the second node N2. The driving thin-film transistor Tdr may control a data current based on the target voltage held in the storage capacitor Cst and supply the data current to the light emitting device layer EDL through the fourth thin-film transistor T4 to drive the light emitting device layer EDL, thereby controlling a luminance of the light emitting device layer EDL based on the amount of the data current.

The light emitting device layer (or a light emitting device part) EDL may be configured to emit light of luminance corresponding to the amount of current supplied from the pixel circuit PC. For example, the light emitting device layer EDL may generate light of brightness proportional to the amount of data current supplied from the driving thin-film transistor Tdr. The display panel 10 or the light emitting element layer EDL according to an embodiment of the present disclosure may be configured to have a top emission structure.

The light emitting device layer EDL according to an embodiment of the present disclosure may include a first electrode (or an anode electrode or reflective electrode) connected to the first node N1 of the driving thin-film transistor Tdr through the fourth thin-film transistor T4, a second electrode (or a cathode electrode or a transparent electrode) connected to a common voltage line CVL, and an emission part formed (or interposed) between the first electrode and the second electrode. For example, the emission part may be a light emitting layer, an organic light emitting layer, a light emitting stack part, or an organic light emitting device. For example, the emission part may include one or more light emitting stacks. For example, the common voltage line CVL may be configured to receive a common voltage (or a low potential voltage or a cathode voltage) ELVSS. The light emitting device layer EDL may generate light of brightness proportional to the amount of data current supplied from the driving thin-film transistor Tdr through the fourth thin-film transistor T4. For example, light generated from the emission part may be emitted to an outside through the second electrode.

The light emitting display apparatus or the sub-pixel SP according to an embodiment of the present disclosure may further include a scattering layer.

The scattering layer may be configured in an extraction path of light emitted from the light emitting device layer EDL. The scattering layer may be configured on the light emitting device layer EDL to increase scattering characteristics of light emitted from the light emitting device layer EDL. Thus, the scattering layer may increase (or improve) luminance viewing angle characteristics and an amount of light extraction of the plurality of sub-pixels SP or the display panel 10. Furthermore, due to the increase in the amount of light extraction of the plurality of sub-pixels SP or the display panel 10 by the scattering layer, low-power driving of the sub-pixel SP is possible, and thus, power consumption of the light emitting display apparatus may be reduced.

The scattering layer may be on the second electrode of the light emitting device layer EDL. The scattering layer may be disposed on the second electrode of the light emitting device layer EDL to have a light scattering surface (or unevenness or irregular unevenness). For example, the scattering layer may be made of a material capable of having a light scattering surface (or unevenness or irregular unevenness) by an intermolecular stack structure. For example, the scattering layer may be made of an organic material, but is not limited thereto. The scattering layer according to an embodiment may be configured (or formed) in an entire surface of the display area AA of the display panel 10 or the substrate 100, but is not limited thereto. For example, the scattering layer may be a corrugation layer, an uneven layer, or a roughness layer, but is not limited thereto. A detailed description of such a scattering layer will be described below.

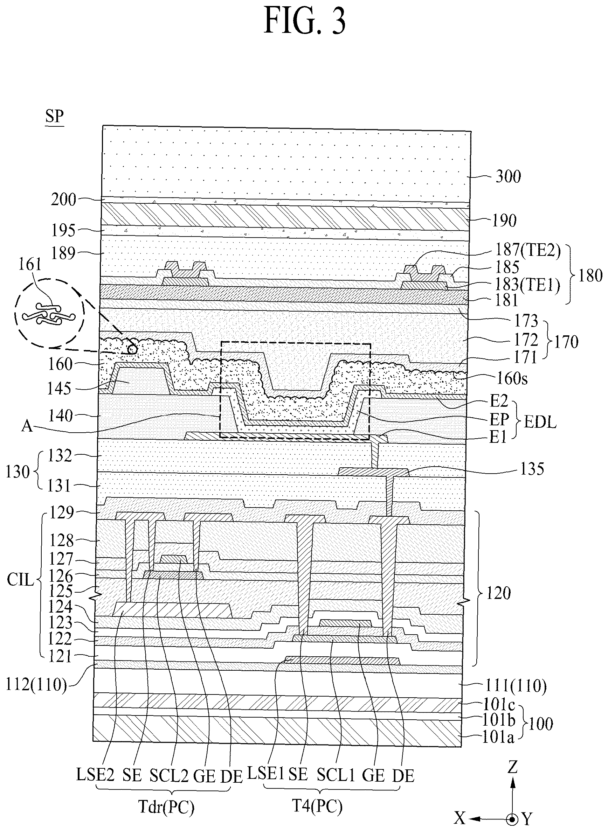

FIG. 3 is a cross-sectional view illustrating an example of a structure of one sub-pixel illustrated in FIGS. 1 and 2. FIG. 3 representatively illustrates a fourth thin film transistor T4 which is an LTPS transistor and a driving transistor Tdr which is an oxide transistor, in the sub-pixel.

Referring to FIGS. 1 to 3, the light emitting display apparatus (or display panel 10 or sub-pixel SP) according to an embodiment of the present disclosure may include a substrate 100; a light emitting device layer EDL configured on the substrate 100 and including a first electrode E1, an emission part EP, and a second electrode E2; a scattering layer 160 on the second electrode E2; and a protection layer 170 on the scattering layer 160.

The light emitting display apparatus (or display panel 10 or sub-pixel SP) according to an embodiment of the present disclosure may further include a buffer layer 110 on the substrate 100, a pixel circuit part 120 on the buffer layer 110, and a planarization layer 130 covering the pixel circuit part 120. The buffer layer 110, the pixel circuit part 120, and the planarization layer 130 may be configured (or formed) between the substrate 100 and the light emitting device layer EDL.

The substrate 100 may include a first base substrate 101a, an interlayer insulating layer 101b, and a second base substrate 101c. The first base substrate 101a and the second base substrate 101c may include a flexible polymer resin. For example, the first base substrate 101a and the second base substrate 101c may be polyimide films, but are not limited thereto. The interlayer insulating layer 101b may include an inorganic insulating material, but is not limited thereto.

The buffer layer 110 may be disposed on the substrate 100. The buffer layer 110 may serve to block materials contained in the substrate 100 from diffusing into transistors during a high-temperature process among manufacturing processes of the thin-film transistor, or may also serve to prevent external water and/or moisture (or moisture and/or humidity) from permeating toward the pixel circuit PC and/or the light emitting device layer EDL.

The buffer layer 110 may be a multi-buffer layer disposed on the second base substrate 101c. For example, the buffer layer 110 may include a first buffer layer 111a disposed on the second base substrate 101c, and a second buffer layer 111b stacked on the first buffer layer 111a. For example, the first buffer layer 111a and the second buffer layer 111b may include a same or different inorganic insulating materials.

The pixel circuit part 120 may include a pixel circuit PC on the buffer layer 110 of the display area AA, and a circuit insulation layer CIL insulating the pixel circuit PC.

The pixel circuit PC may include a plurality of thin-film transistors including a driving thin-film transistor Tdr disposed in a pixel area on the buffer layer 110.

The fourth thin-film transistor T4 disposed in the pixel P may include a first light-shielding electrode LSE1 disposed on the buffer layer 110, a first active buffer layer 121 covering the first light-shielding electrode LSE1, a first semiconductor layer SCL1 disposed on the first active buffer layer 121, a first gate insulation layer 122 covering the first semiconductor layer SCL1, and a gate electrode GE disposed on the first gate insulation layer 122. The first semiconductor layer SCL1 may include LTPS.

The fourth thin-film transistor T4 may further include a plurality of first interlayer insulating layers 123 and 124, a second active buffer layer 125, a second gate insulation layer 126, and a plurality of second interlayer insulation layers 127 and 128 which are stacked on the gate electrode GE, and a source electrode SE and a drain electrode DE which are disposed on an uppermost interlayer insulation layer 128 among a plurality of second interlayer insulation layers 127 and 128 and connected to the first semiconductor layer SCL1 through a plurality of contact holes penetrating the second interlayer insulation layers 127 and 128, the second gate insulation layer 126, the second active buffer layer 125, the plurality of first interlayer insulating layers 123 and 124, and the first gate insulation layer 122. For example, the fourth thin-film transistor T4 may be formed in a dual gate structure.

The driving thin-film transistor Tdr may include a second light-shielding electrode LSE2 disposed on an uppermost interlayer insulation layer 124 among the plurality of first interlayer insulation layers 123 and 124, a second active buffer layer 125 covering the second light-shielding electrode LSE2, a second semiconductor layer SCL2 disposed on the second active buffer layer 125, a second gate insulation layer 126 covering the second semiconductor layer SCL2, and a gate electrode GE disposed on the second gate insulation layer 126. The second semiconductor layer SCL2 may include an oxide semiconductor or a metal oxide semiconductor.

The driving thin-film transistor Tdr may include a source electrode SE and a drain electrode DE disposed on the uppermost interlayer insulation layer 128 among the plurality of second interlayer insulation layers 127 and 128 which are stacked on the gate electrode GE and connected to the second semiconductor layer SCL2 through a plurality of contact holes penetrating the plurality of second interlayer insulation layers 127 and 128 and the second gate insulation layer 126.

The source electrode SE of the driving thin-film transistor Tdr may be connected to the second light-shielding electrode LSE2 through a contact hole penetrating the plurality of second interlayer insulation layers 127 and 128, the second gate insulation layer 126, and the second active buffer layer 125.

Referring to FIGS. 2 and 3, each of the first thin-film transistor T1 and the fifth thin-film transistor T5 disposed in the pixel P is formed together with the driving thin-film transistor Tdr, and thus, a repetitive description thereof is omitted. Each of the second thin-film transistor T2 and the third thin-film transistor T3 disposed in the pixel P is formed together with the fourth thin-film transistor T4, and thus, a repetitive description thereof is omitted. For example, the third thin-film transistor T3 may be formed in a dual gate structure.

The first scan line SL1 and the second emission control line ECL2 of the gate line GL, the gate electrodes GE of each of the driving thin-film transistor Tdr and the first and fifth thin-film transistors T1 and T5, and the initialization voltage line IVL may be formed of a second gate metal layer disposed on the second semiconductor layer SCL2.

The second scan line SL2 and the first emission control line ECL1 of the gate line GL, and the gate electrodes GE of each of the second to fourth thin-film transistors T2, T3, and T4 may be formed as a first gate metal layer disposed on the first semiconductor layer SCL1.

The source electrode and the drain electrode SE and DE of each of the driving thin-film transistor Tdr and the first to fifth thin-film transistors T1 to T5, and the data line DL, may be formed as a first source/drain metal layer disposed on the second gate metal layer.

The storage capacitor Cst may include a first capacitor electrode and a second capacitor electrode. The first capacitor electrode of the storage capacitor Cst may be formed of the second gate metal layer and integrally formed (or one body) with the gate electrode of the driving thin-film transistor Tdr, and may be connected to the first thin-film transistor T1 through the third node N3. The second capacitor electrode of the storage capacitor Cst may be formed as a second light-shielding metal layer and may be commonly connected to the fourth and fifth thin-film transistors T4 and T5 through the output node No.

A passivation layer 129 may be disposed on the pixel circuit PC. The passivation layer 129 may be disposed on the substrate 100 to cover the pixel circuit PC.

A circuit insulation layer CIL may be disposed (or formed) to electrically insulate between metal layers of the pixel circuit PC. The circuit insulation layer CIL may include the first and second active buffer layers 121 and 125, the first and second gate insulation layers 122 and 126, the plurality of first interlayer insulation layers 123 and 124, the plurality of second interlayer insulation layers 127 and 128, and the passivation layer 129. For example, the circuit insulation layer CIL may be an inorganic insulation layer, an inorganic insulation material layer, a pixel insulation layer, or a pixel circuit insulation layer, but is not limited thereto. For example, the circuit insulation layer CIL may expand (or extend) from the display area AA of the substrate 100 to a partial area of a non-display area IA adjacent to an end of the substrate 100.

The planarization layer 130 may be configured (or formed) to cover the pixel circuit part 120. For example, the pixel circuit part 120 may include all layers disposed between the buffer layer 110 and the passivation layer 129.

The planarization layer 130 may include a stacked structure of two or more planarization layers 131 and 132. The two or more planarization layers 131 and 132 may have a same thickness or may have different thicknesses. The two or more planarization layers 131 and 132 may be made of an organic material. For example, the two or more planarization layers 131 and 132 may be formed of an organic material such as an acrylic resin, an epoxy resin, a phenolic resin, a polyamide resin, or a polyimide resin.

The planarization layer 130 according to an embodiment may include first and second planarization layers 131 and 132, but is not limited thereto. For example, the planarization layer 130 may further include a third planarization layer stacked on the second planarization layer 132.

The first planarization layer 131 may be configured (or formed) to cover the pixel circuit part 120. For example, the first planarization layer 131 may be configured (or formed) to cover the passivation layer 129 of the pixel circuit part 120.

A connection electrode 135 may be formed on the first planarization layer 131. The connection electrode 135 may be formed of the second source/drain metal layer. The connection electrode 135 may be connected to the drain electrode DE (or source electrode SE) of the fourth thin-film transistor T4 through a contact hole penetrating the passivation layer 129 and the first planarization layer 131. The connection electrode 135 may be configured to stably connect the drain electrode DE (or source electrode SE) of the fourth thin-film transistor T4 and a first electrode E1 of a light emitting device layer EDL.

The pixel driving voltage line PL may be formed together with the connection electrode 135 on the first planarization layer 131. The pixel driving voltage line PL may be formed of the second source/drain metal layer. The pixel driving voltage line PL may be connected to a source electrode SE (or a drain electrode DE) of the third thin-film transistor T3 through a contact hole penetrating the passivation layer 129 and the first planarization layer 131.

The second planarization layer 132 may be disposed on the connection electrode 135. The second planarization layer 132 may be stacked (or formed) on the first planarization layer 131 to cover the connection electrode 135. The third planarization layer may be additionally disposed on the second planarization layer 132.

The light emitting device layer EDL may be disposed (or configured) on the planarization layer 130 of the display area AA. The light emitting device layer EDL may be disposed on a flat surface of the second planarization layer 132.

The light emitting device layer EDL may include a first electrode E1, an emission part EP, and a second electrode E2 which are stacked and disposed on the second planarization layer 132.

The first electrode (or an anode electrode) E1 may be connected to the connection electrode 135 through a contact hole penetrating the second planarization layer 132. For example, the first electrode E1 may be individually (or independently) configured (or formed) in each of the plurality of pixels. For example, the first electrode E1 may include one or more conductive layer structures having high reflectivity. For example, the first electrode E1 may include a single-layer structure or a multi-layer structure made of any one material selected from aluminum Al, silver Ag, molybdenum Mo, gold Au, magnesium Mg, calcium Ca, or barium Ba, or two or more alloy materials thereof.

The emission part EP may be configured between the first electrode E1 and the second electrode E2.

The emission part EP according to an embodiment may include an organic light emitting structure stacked on the first electrode E1 in the order or in reverse order of a hole functional layer, one or more light emitting layers (or organic light emitting layers), and an electron functional layer. The one or more light emitting layers may be disposed (or interposed) between the hole functional layer and the electron functional layer.

According to an embodiment, the emission part EP may include a tandem structure in which two light emitting layers are overlapped (or stacked), and may further include a charge generation layer interposed between the two light emitting layers, but is not limited thereto. For example, the emission part EP may include three or more light emitting stack structures in which three or more light emitting layers are overlapped (or stacked), and may further include two or more charge generation layers interposed between the three or more light emitting stack structures.

According to an embodiment, the emission part EP may be individually configured in each of the plurality of sub-pixels SP. For example, the emission part EP may be implemented to generate color light corresponding to a corresponding sub-pixel SP. For example, the emission part EP of a red sub-pixel SP includes a red organic light emitting layer, the emission part EP of a green sub-pixel SP includes a green organic light emitting layer, and the emission part EP of a blue sub-pixel SP may include a blue organic light emitting layer.

In the emission part EP according to another embodiment, the hole functional layer and the electron functional layer of the organic light emitting structure may be a common layer (or a common organic layer). The common layer may be disposed in an entire area of the display area AA and a partial area of a non-display area IA. For example, the common layer may be commonly and identically disposed in the plurality of sub-pixels. For example, the hole functional layer may include one or more of a hole injection layer and a hole transport layer, and the electron functional layer may include one or more of an electron injection layer and an electron transport layer.

The second electrode E2 may be disposed on the emission part EP. The second electrode E2 may be configured to be electrically connected to the common voltage line CVL. The second electrode E2 may be formed of a conductive material with high light transmittance or a semi-transmissive conductive material. For example, the second electrode E2 may be commonly configured (or formed) in the plurality of sub-pixels SP, but is not limited thereto, and may include a plurality of second electrode patterns at least partially separated.

The second electrode E2 according to an embodiment of the present disclosure may be made of a transparent conductive oxide. For example, the second electrode E2 may be made of a transparent conductive oxide such as indium-tin-oxide (ITO), indium-zinc-oxide (IZO), or indium-gallium-zinc-oxide (IGZO), but is not limited thereto.

The second electrode E2 according to another embodiment of the present disclosure may be made of an AgMg (or Mg:Ag) material. For example, the second electrode E2 may be configured as a single thin-film layer (or an alloy single layer) made of an alloy material of silver Ag and magnesium Mg, or may be configured as a stacked thin-film layer of silver Ag and magnesium Mg.

The light emitting display apparatus (or display panel 10 or sub-pixel SP) according to an embodiment of the present disclosure may further include a bank insulation layer 140 and a spacer 145.

The bank insulation layer 140 may be on the planarization layer 130 and may be configured to define an opening area (or an emission area) of each of the plurality of sub-pixels SP disposed in the display area AA. The bank insulation layer 140 may be disposed (or configured) in a non-opening area (or a non-emission area) of each of the plurality of sub-pixels SP to define the opening area (or the emission area) of each of the plurality of sub-pixels SP.

The bank insulation layer 140 may be configured to cover an end portion (or an edge portion) of the first electrode E1. For example, the bank insulation layer 140 may include a mesh shape. Accordingly, the remaining part except for the end portion of the first electrode E1 may be defined as the opening area (or emission area) of the sub-pixel SP.

The bank insulation layer 140 may include a black material, a light-shielding material, and a light-absorbing material. The bank insulation layer 140 may include a material that absorbs a specific wavelength. The bank insulation layer 140 may include a structure in which color filters of at least two different colors among a red color filter, a green color filter, and a blue color filter which are stacked.

The emission part EP is directly in contact with the remaining part except for the end portion of the first electrode E1, and may be directly in contact with a portion of the bank insulation layer 140 covering the end portion of the first electrode E1. The second electrode E2 may be a common electrode continuously connected along a surface of the bank insulation layer 140.

The spacer 145 may be disposed on the bank insulation layer 140. The spacer 145 may protrude from the bank insulation layer 140 or may be disposed on the bank insulation layer 140 and be made from the same material as the bank insulation layer 140. For example, the spacer 145 may be configured to support a deposition mask for forming the emission part EP, but is not limited thereto. For example, the spacer 145 may be a bank protrusion. The second electrode E2 may be configured (or formed) to cover the emission part EP, the bank insulation layer 140, and the spacer 145.

The scattering layer 160 is configured on the light emitting device layer EDL to increase scattering characteristics of light emitted from the emission part EP, thereby increasing (or improving) luminance viewing angle characteristics and light extraction amount of the plurality of sub-pixels SP or the display panel 10.

The scattering layer 160 according to an embodiment of the present disclosure may be disposed on the second electrode E2 of the light emitting device layer EDL. For example, the scattering layer 160 may be directly in contact with a surface of the second electrode E2. The scattering layer 160 may be disposed at the entire display area AA and a portion of the non-display area IA. For example, the scattering layer 160 may expand (or extend) from the display area AA of the substrate 100 to a partial area of the non-display area IA adjacent to an end of the substrate 100.

The scattering layer 160 may be configured (or formed) to include a light scattering surface (or unevenness or irregular unevenness or roughness) 160s. The scattering layer 160 may be made of a material (or an organic material) capable of forming a desired light scattering surface 160s by way of an intermolecular stacking structure. For example, the scattering layer 160 may be made of a material (or an organic material) that can feature a rough surface as a result of an intermolecular stacking structure formed during a manufacturing process (or deposition).

According to an embodiment of the present disclosure, the scattering layer 160 may be configured (or formed) to include the light scattering surface 160s through (or through only) a deposition process of a material without an additional separate patterning process. For example, the scattering layer 160 may be formed through (or through only) a thermal evaporation process, but is not limited thereto. For example, the scattering layer 160 is formed to include the light scattering surface 160s only by the deposition process of the material, and thus, may be processively, structurally, and materially distinguished from a light scattering surface (or micro lens) formed on a separate organic material layer disposed on the light emitting device layer EDL by a separate patterning process (or an ashing process) using a photoresist, or from a separate micro lens film.

According to an embodiment, a molecular structure 161 of a material suitable for forming the scattering layer 160 having the light scattering surface 160s may include an organic material including a plurality of aromatic rings and a double bond structure, and two or more of the plurality of aromatic rings may be rotated relative to a plane including the double bond structure and the atoms of the aromatic rings that are directly bonded to the double bond structure (or disposed in a rotated conformation).

According to an embodiment, a molecular weight of a material suitable for forming the scattering layer 160 may be 500 or less, and its molecular structure 161 may have a diameter of 10 Å to 25 Å. For example, in a molecular structure 161 of a material suitable for forming the scattering layer 160, the number of aromatic rings may be four or five, and the number of double bond structures may be one. For example, when the molecular structure 161 has a diameter of 10 Å to 25 Å, the number of aromatic rings may be four or five.

According to an embodiment, in the molecular structure 161 of the material suitable for forming the scattering layer 160, as the number of rotated aromatic rings among the plurality of aromatic rings increases, the degree of freedom of the molecule structure 161 may increase, and thus, the degree of roughness (or surface roughness) of the light scattering surface 160s of the scattering layer 160 may increase. For example, a material (or molecule structure 161) of the scattering layer 160 may form the light scattering surface 160s having a concave-convex (or roughness) structure through self-aggregation (or self-crystallization) based on an asymmetric interaction when stacking molecules by using the deposition process. The light scattering surface 160s may increase a scattering characteristic of light passing through the scattering layer 160, and thus, may increase (or enhance) a luminance viewing angle characteristic and light extraction efficiency of the plurality of sub-pixels SP or the display panel 10.

The scattering layer 160 according to an embodiment of the present disclosure may include a tetraphenylethylene (TPE)-based molecular structure, but is not limited thereto.

The scattering layer 160 according to a first embodiment may include a tetraphenylethylene (TPE)-based molecular structure including four aromatic rings and four rotated aromatic rings as in the following Chemical Formula 1.

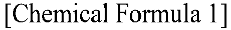

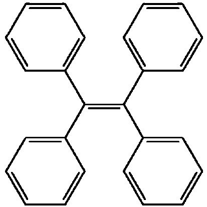

The scattering layer 160 according to a second embodiment may include a tetraphenylethylene (TPE)-based molecular structure including five aromatic rings and two rotated aromatic rings as in the following Chemical Formula 2.

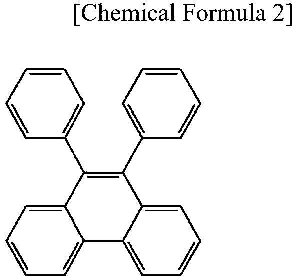

The scattering layer 160 according to a third embodiment may include a tetraphenylethylene (TPE)-based molecular structure including four aromatic rings and two rotated aromatic rings as in the following Chemical Formula 3.

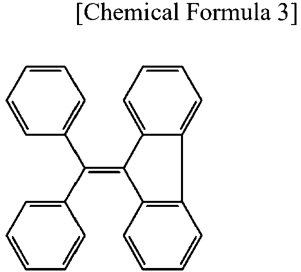

The scattering layer 160 according to a fourth embodiment may include a tetraphenylethylene (TPE)-based molecular structure including four aromatic rings and two rotated aromatic rings as in the following Chemical Formula 4.

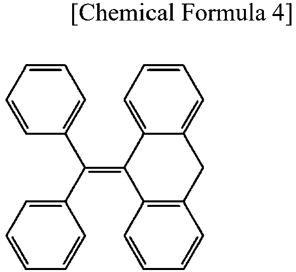

The scattering layer 160 according to a fifth embodiment may include bathocuproine (BCP) as in the following Chemical Formula 5. For example, bathocuproine (BCP) may be a diazapolycyclic aromatic compound and may be 2,9-dimethyl-4,7-diphenyl-1,10-phenanthroline (C₂₄H₂₀N₂), but is not limited thereto.

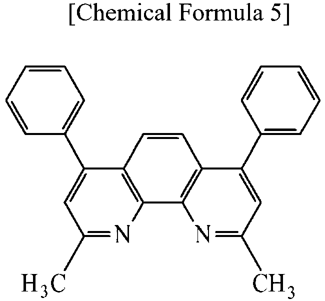

The scattering layer 160 according to a sixth embodiment may include triphenylamine derivatives (TPD) as in the following Chemical Formula 6. For example, the triphenylamine derivatives (TPD) may be an aromatic amine compound and may be N,N'-diphenyl-N,N'-bis(3-methylphenyl)-[1,1'-biphenyl]-4,4'-diamine (C₃₈H₃₂N₂), but is not limited thereto.

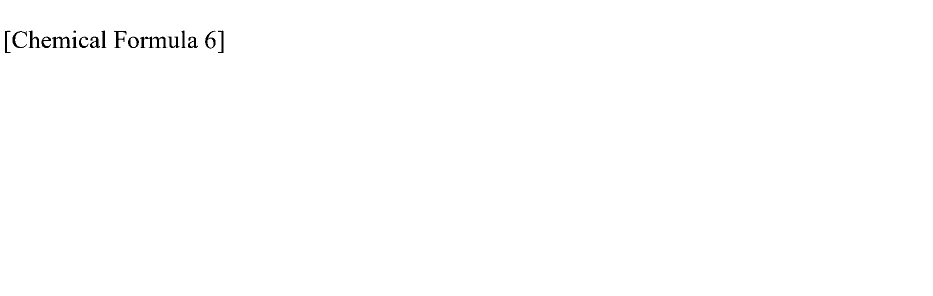

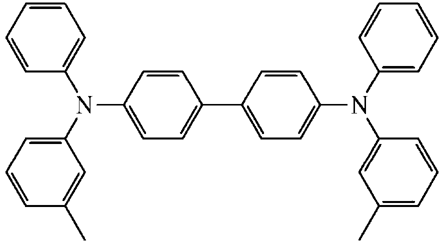

The scattering layer 160 according to a seventh embodiment may include bathophenanthroline (BPhen) as in the following Chemical Formula 7. For example, bathophenanthroline (BPhen) may be an aromatic dimer compound and may be 4,7-diphenyl-1,10-phenanthroline (C₂₄H₁₆N₂), but is not limited thereto.

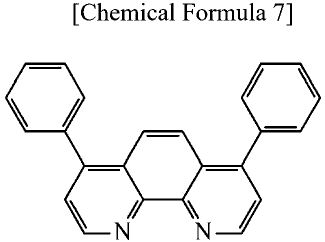

The scattering layer 160 according to an eighth embodiment may include perylene derivatives as in the following Chemical Formula 8. For example, the perylene derivatives may be an aromatic hydrocarbon compound and may be N,N'-ditridecylperylene-3,4,9,10-tetracarboxylic diimide (PTCDI-C₁₃H₂₇ or C₅₀H₆₂N₂O₄), but is not limited thereto.

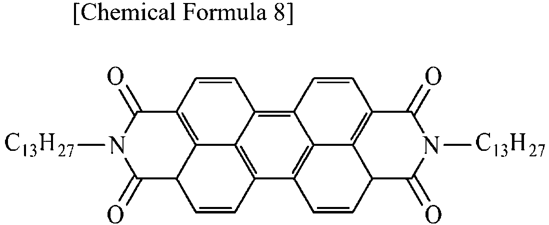

According to a ninth embodiment, the scattering layer 160 may include pentacene derivatives as in the following Chemical Formula 9. For example, the pentacene derivatives may be a polycyclic aromatic hydrocarbon compound and may be 6,13-diphenylpentacene (C₂₂H₁₄), but is not limited thereto.

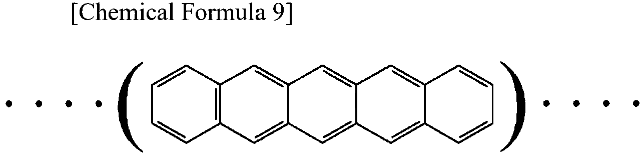

The scattering layer 160 according to another embodiment of the present disclosure may include one of bathocuproine, triphenylamine derivatives, bathophenanthroline, perylene derivatives, and pentacene derivatives, but is not limited thereto.

The protection layer 170 may be disposed (or formed) on the scattering layer 160. The protection layer 170 may be disposed (or formed) to cover the scattering layer 160. For example, the protection layer 170 may be disposed (or formed) to cover an entire scattering layer 160. The protection layer 170 may be disposed (or formed) to seal the light emitting device layer EDL. The protection layer 170 may be configured to prevent moisture and/or oxygen from penetrating into the light emitting device layer EDL and to prevent flow of particles by covering the particles. For example, the protection layer 170 may be an encapsulation layer or an encapsulation part.

The protection layer (or encapsulation layer) 170 according to an embodiment may include one or more inorganic encapsulation layers and one organic encapsulation layer. For example, the protection layer (or encapsulation layer) 170 may include first to third encapsulation layers 171, 172, and 173.

The first encapsulation layer 171 may be disposed (or formed) on the scattering layer 160. The first encapsulation layer 171 may be disposed (or formed) to seal the light emitting device layer EDL and to cover the scattering layer 160. The first encapsulation layer 171 may be disposed (or formed) to contact (or directly contact) the light scattering surface 160s of the scattering layer 160. The first encapsulation layer 171 may be an inorganic encapsulation layer made of an inorganic material.

The second encapsulation layer 172 may be disposed (or formed) on the first encapsulation layer 171. The second encapsulation layer 172 may be disposed on the first encapsulation layer 171 in the display area AA of the substrate 100. The second encapsulation layer 172 may be an organic encapsulation layer made of an organic material. The second encapsulation layer 172 may be prevented from overflowing by a dam disposed at an edge portion of the substrate 100.

The third encapsulation layer 173 may be disposed on the second encapsulation layer 172 to cover the second encapsulation layer 172. The third encapsulation layer 173 may cover the second encapsulation layer 172 and be disposed on the first encapsulation layer 171 in the non-display area IA of the substrate 100. The third encapsulation layer 173 may be an inorganic encapsulation layer made of an inorganic material. The third encapsulation layer 173 may be disposed to surround the second encapsulation layer 172 together with the first encapsulation layer 171 in the display area AA. For example, the second encapsulation layer 172 may be interposed between the first encapsulation layer 171 and the third encapsulation layer 173 surrounded by the dam in the display area AA of the substrate 100.

Each of the first encapsulation layer 171 and the third encapsulation layer 173 may expand (or extend) from the display area AA of the substrate 100 to a partial area of the non-display area IA adjacent to the end portion of the substrate 100. For example, in the non-display area IA, the third encapsulation layer 173 may be disposed to directly contact the first encapsulation layer 171. For example, one or more of the first encapsulation layer 171 and the third encapsulation layer 173 may be configured to cover an end portion of the circuit insulation layer CIL in a partial area of the non-display area IA adjacent to the end portion of the substrate 100, but is not limited thereto.

The light emitting display apparatus (or display panel 10) according to an embodiment of the present disclosure may further include a touch sensing part 180.

The touch sensing part 180 may be disposed (or formed) on the protection layer 170. For example, the touch sensing part 180 may be disposed on the third encapsulation layer 173 of the protection layer 170 disposed in the display area AA of the substrate 100. As an example, the touch sensing part 180 may include a touch electrode layer including a plurality of touch driving lines and a plurality of touch sensing lines based on a mutual capacitance method. As another example, the touch sensing part 180 may include a touch electrode layer including a plurality of touch electrodes based on a self-capacitance method.

The touch sensing part 180 according to an embodiment may include a touch buffer layer 181, a first touch electrode layer 183, a touch insulation layer 185, and a second touch electrode layer 187.

The touch buffer layer 181 may be disposed (or formed) on the protection layer 170. The touch buffer layer 181 may be disposed on the third encapsulation layer 173 of the protection layer 170. For example, the touch buffer layer 181 may be made of an inorganic material. The touch buffer layer 181 may expand (or extend) from the display area AA of the substrate 100 to a partial area of the non-display area IA adjacent to the end portion of the substrate 100. For example, the touch buffer layer 181 may be configured to cover the end portion of the circuit insulation layer CIL in the partial area of the non-display area IA adjacent to the end portion of the substrate 100, but is not limited thereto. For example, the touch buffer layer 181 may be configured to cover ends of the first encapsulation layer 171 and the third encapsulation layer 173 in the partial area of the non-display area IA adjacent to the end portion of the substrate 100, but is not limited thereto.

The first touch electrode layer 183 may include a plurality of first touch electrodes TE1 disposed on the touch buffer layer 181. The plurality of first touch electrodes TE1 may be made of a transparent metal or made of an opaque metal. For example, the plurality of first touch electrodes TE1 may be a plurality of bridge electrodes or a plurality of bridge wires, but is not limited thereto. For example, the plurality of first touch electrodes TE1 may include a mesh structure made of a plurality of fine lines.

The touch insulation layer 185 may be disposed on the touch buffer layer 181 to cover the first touch electrode layer 183. The touch insulation layer 185 may be made of an inorganic material, but is not limited thereto, and may also be made of an organic material.

The second touch electrode layer 187 may include a plurality of second touch electrodes TE2 disposed on the touch insulation layer 185. The plurality of second touch electrodes TE2 may be made of a transparent metal or made of an opaque metal. For example, the plurality of second touch electrodes TE2 may be a plurality of touch sensing electrodes or a plurality of touch driving electrodes, but is not limited thereto. For example, each of the plurality of second touch electrode layers TE2 may include a mesh structure made of a plurality of fine lines.

In the second touch electrode layer 187, each of the plurality of second touch electrodes TE2 disposed adjacently along a first direction X or a second direction Y may be connected to each of the plurality of first touch electrodes TE1 through a via hole provided in the touch insulation layer 185. Thus, each of the plurality of second touch electrodes TE2 disposed adjacently along the first direction X or the second direction Y may be connected to each other through the plurality of first touch electrodes TE1. For example, the plurality of second touch electrodes TE2 disposed adjacently along the second direction Y may be connected to each other through the plurality of first touch electrodes TE1.

The light emitting display apparatus (or display panel 10) or the touch sensing part 180 according to an embodiment of the present disclosure may further include a touch protection layer 189.

The touch protection layer 189 may be disposed on the touch insulation layer 185 to cover the second touch electrode layer 187. The touch protection layer 189 may be configured to planarize an upper portion of the touch sensing part 180. The touch protection layer 189 may be formed of an organic material, but is not limited thereto. For example, the touch protection layer 189 may expand (or extend) from the display area AA of the substrate 100 to the partial area of the non-display area IA adjacent to the end portion of the substrate 100.

The touch protection layer 189 according to an embodiment may be formed of an organic material such as an acrylic resin, an epoxy resin, a phenolic resin, a polyamide resin, or a polyimide resin.

The light emitting display apparatus (or display panel 10) according to an embodiment of the present disclosure may further include an optical film 190.

The optical film 190 may include an anti-reflection layer (or an anti-reflection film) attached on the touch sensing part 180 or the touch protection layer 189. For example, the optical film 190 may include a polarizing film or a circular polarizing film, but is not limited thereto. The optical film 190 may be attached to the touch sensing part 180 or the touch protection layer 189 by using an adhesive member 195.

The light emitting display apparatus (or display panel 10) according to an embodiment of the present disclosure may further include a color filter layer.

The color filter layer may include a plurality of color filters corresponding to (or overlapping) the opening area (or emission area) of each of the plurality of sub-pixels SP. For example, the color filter layer may include a plurality of red color filters corresponding to (or overlapping) an opening area (or an emission area) of each of a plurality of red sub-pixels, a plurality of green color filters corresponding to (or overlapping) an opening area (or an emission area) of each of a plurality of green sub-pixels, and a plurality of blue color filters corresponding to (or overlapping) an opening area (or an emission area) of each of a plurality of blue sub-pixels.

The color filter layer may further include a light shielding layer disposed (or configured) in the non-opening area (or non-emission area) of each of the plurality of sub-pixels SP. The light shielding layer may be disposed (or configured) between the plurality of red color filters, the plurality of green color filters, and the plurality of blue color filters to correspond to (or overlap) the non-opening area (or non-emission area) of each of the plurality of sub-pixels SP.

The color filter layer may further include a filter protection layer covering the light shielding layer. The filter protection layer may be formed (or configured) to provide a flat surface on an upper surface of the color filter layer. For example, the filter protection layer may be made of an organic material or an inorganic material.

The light emitting display apparatus (or display panel 10) according to an embodiment of the present disclosure may include both the optical film 190 and the color filter layer, but is not limited thereto. For example, the light emitting display apparatus (or display panel 10) may include only any one of or one or more of the optical film 190 and the color filter layer.

The light emitting display apparatus according to an embodiment of the present disclosure may further include a cover window 300.

The cover window 300 may be configured to protect the display panel 10. The cover window 300 may be attached to the optical film 190 (or the color filter layer) by using an optical adhesive member 200. The cover window 300 may have a size larger than the display panel 10 and be made of a transparent material. For example, the cover window 300 may be made of a plastic material or a glass material.

The display apparatus (or display panel 10) according to an embodiment of the present disclosure may further include a transmissive part (or a light transmissive part) disposed in the display area AA. For example, the transmissive part may be disposed in (within) one unit pixel so as not to overlap the pixel circuit PC. For example, the second electrode E2 may be disposed in (within) the display area AA so as not to overlap the transmissive part.

As described above, the light emitting display apparatus according to an embodiment of the present disclosure includes the scattering layer 160 having the light scattering surface 160s, whereby scattering characteristics of light emitted from the light emitting device layer EDL may be increased by the scattering layer 160, and due to this, luminance viewing angle characteristics and light extraction amount of the plurality of sub-pixels SP or the display panel 10 may be increased (or improved). Therefore, the light emitting display apparatus according to an embodiment of the present disclosure may have reduced power consumption due to low-power driving based on an increase in the amount of light extraction.

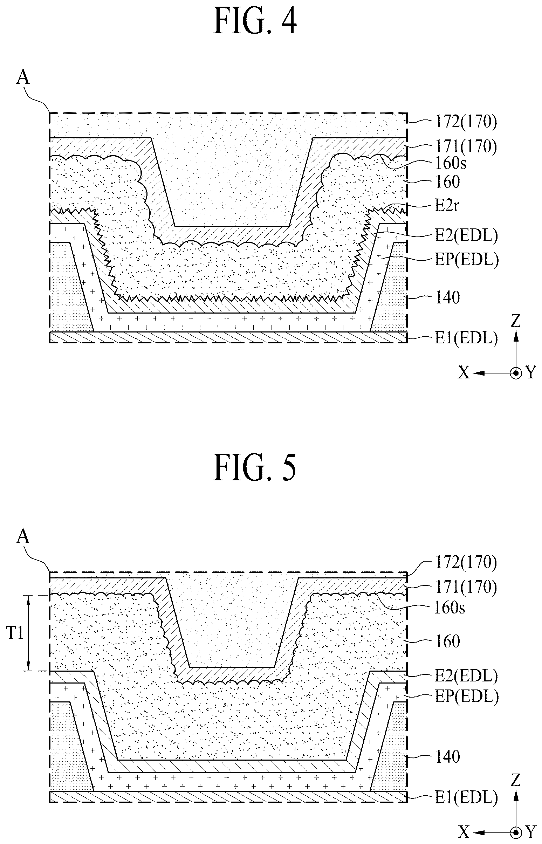

FIG. 4 is an enlarged view of a portion A illustrated in FIG. 3. FIG. 4 is a diagram for describing the second electrode and the scattering layer described above with reference to FIGS. 1 to 3.

Referring to FIGS. 3 and 4, in the light emitting display apparatus (or display panel 10) according to an embodiment of the present disclosure, the scattering layer 160 is uniformly deposited on the surface of the second electrode E2 made of a material having a relatively high surface energy, and thus, the scattering layer 160 may be stably deposited (or formed) on (or at) a surface of the second electrode E2. For example, as the surface energy of the second electrode E2 of the light emitting device layer EDL becomes higher, the scattering layer 160 may be more stably deposited (or formed) on (or at) the second electrode E2, and an adhesive force between the scattering layer 160 and the second electrode E2 may increase.

According to an embodiment, since the transparent conductive oxide has a relatively low surface energy of approximately 30 to 50 mN/m, when the scattering layer 160 is formed on the second electrode E2 made of the transparent conductive oxide, the light scattering surface 160s may not be formed on (or at) the second electrode E2.

According to another embodiment, since the AgMg material has a relatively high surface energy of 800 to 1200 mN/m, when the scattering layer 160 is formed on (or at) the second electrode E2 made of the AgMg material, the light scattering surface 160s may be stably formed on (or at) the second electrode E2.

According to an embodiment of the present disclosure, the surface energy of the second electrode E2 may be increased through surface modification (for example, surface roughness, adhesive force, hydrophilicity, physical surface modification, chemical surface modification, etc.) of the second electrode E2 using a preprocessing (or a pre-treatment process) (for example, an oxygen plasma process). For example, even if the second electrode E2 is made of a material having a low surface energy, the surface energy of the second electrode E2 is increased by the pre-treatment process, and thus, the scattering layer 160 may be stably deposited on (or at) the surface of the second electrode E2.

According to an embodiment of the present disclosure, when the second electrode E2 is made of a metal material such as a transparent conductive oxide, an oxygen plasma process of irradiating oxygen plasma onto a surface of transparent conductive oxide for tens of seconds or more (for example, 40 sec or more) may be additionally performed. For example, when the oxygen plasma process is performed on the surface of the second electrode E2 made of the transparent conductive oxide, the second electrode E2 made of the transparent conductive oxide may include a surface-modified layer (or a surface modification layer) E2r having a roughness (or surface roughness). For example, the second electrode E2 made of the transparent conductive oxide includes a surface-modified layer E2r surface-treated by oxygen plasma. For example, the second electrode E2 made of the transparent conductive oxide may have a surface energy of a level similar to that of the AgMg material by the oxygen plasma process. Accordingly, when the scattering layer 160 is formed (or deposited) on (or at) the second electrode E2 made of the transparent conductive oxide surface-treated by oxygen plasma, the material of the scattering layer 160 is stably deposited on the surface-modified layer E2r of the second electrode E2 having a high surface energy, and thus, the scattering layer 160 having the light scattering surface 160s may be stably formed (or deposited) on (or at) the second electrode E2.

The surface-modified layer E2r of the second electrode E2 according to an embodiment may have a roughness (for example, root mean square roughness Rq) of 2 nm to 10 nm. The roughness (or surface roughness) of the surface-modified layer E2r may be relatively smaller than the roughness Rq of the scattering layer 160. For example, the surface-modified layer E2r of the second electrode E2 may have a roughness Rq relatively smaller than the roughness Rq of the light scattering surface 160s of the scattering layer 160.

FIGS. 5 to 7 are another enlarged view of a portion A illustrated in FIG. 3. FIGS. 5 to 7 are views for explaining the roughness of the light scattering surface according to the thickness of the scattering layer described above with reference to FIGS. 1 to 3.

Referring to FIGS. 5 to 7, the light scattering surface 160s of the scattering layer 160 according to an embodiment of the present disclosure may have different roughness (or surface roughness) values depending on the thicknesses T1, T2, and T3 of the scattering layer 160.

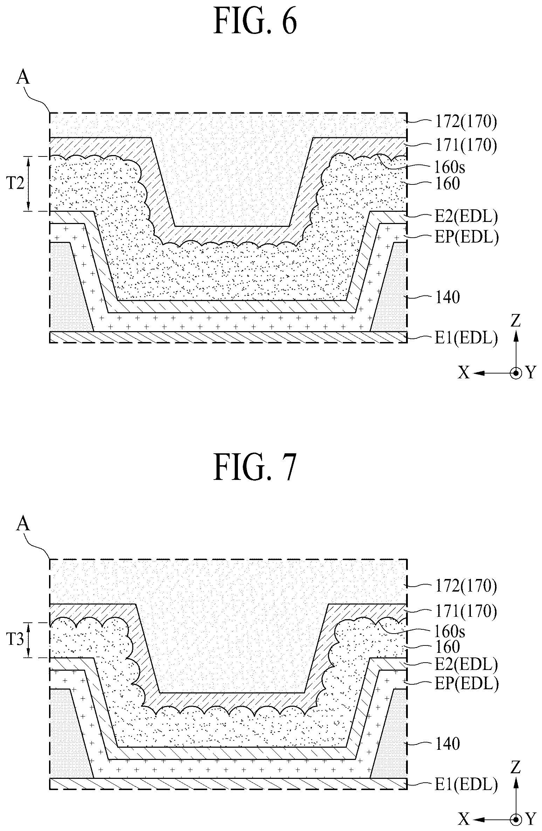

The roughness of the light scattering surface 160s may increase as the thicknesses T1, T2, and T3 of the scattering layer 160 decrease, and as the roughness of the light scattering surface 160s increases, the luminance viewing angle characteristics and the light extraction amount of the plurality of sub-pixels SP (or the display panel 10) may be increased (or improved). For example, when the roughness of the light scattering surface 160s is formed of a plurality of curved shapes, sizes of the plurality of curved shapes may increase as the thicknesses T1, T2, and T3 of the scattering layer 160 decrease. For example, the scattering layer 160 illustrated in FIG. 5 has a first thickness T1, the scattering layer 160 illustrated in FIG. 6 has a second thickness T2 thinner than the first thickness T1, and the scattering layer 160 illustrated in FIG. 7 may have a third thickness T3 thinner than the second thickness T2. Accordingly, the plurality of curved shapes formed on the light scattering surface 160s of the scattering layer 160 having the first thickness T1 may be smaller than the plurality of curved shapes formed on the light scattering surface 160s of the scattering layer 160 having the second thickness T2. Moreover, the plurality of curved shapes formed on the light scattering surface 160s of the scattering layer 160 having the second thickness T2 may be smaller than the plurality of curved shapes formed on the light scattering surface 160s of the scattering layer 160 having the third thickness T3. Therefore, the roughness (for example, root mean square roughness Rq) of the light scattering surface 160s of the scattering layer 160 may increase as the thicknesses T1, T2, and T3 of the scattering layer 160 decrease.

The scattering layer 160 may have a thickness T1, T2, and T3 of 500 Å or more. For example, when the thickness T1, T2, and T3 of the scattering layer 160 is thinner than 500 Å, a non-deposition phenomenon of the scattering layer 160 may occur, and due to this, the luminance viewing angle characteristics may decrease. For example, with reference to a luminance viewing angle of 45 degrees for the plurality of sub-pixels SP (or the display panel 10), there is no limitation on the thickness T1, T2, and T3 of the scattering layer 160, but in consideration of material cost and productivity (or tact time), the scattering layer 160 may be limited to a thickness T1, T2, and T3 of 3000 Å or less. For example, the scattering layer 160 may have a thickness T1, T2, and T3 of 500 Å to 3000 Å.

The scattering layer 160 according to an embodiment may be 680 Å to 2,000 Å, but is not limited thereto. For example, in order to implement the luminance viewing angle characteristics of the plurality of sub-pixels SP (or the display panel 10) to be 70% or more, the thickness T1, T2, and T3 of the scattering layer 160 may be 680 Å or more and 2,000 Å or less.

The light scattering surface 160s of the scattering layer 160 according to an embodiment has a roughness (for example, root mean square roughness Rq) of 10 nm or more, and the scattering layer 160 may have a thickness T1, T2, and T3 of 500 Å or more. For example, in order to implement a luminance viewing angle of 70% or more for white W, the luminance viewing angle for green G should be 60% or more, and thus, the roughness (for example, root mean square roughness Rq) for the light scattering surface 160s of the scattering layer 160 may be 63 nm or more, but is not limited thereto.

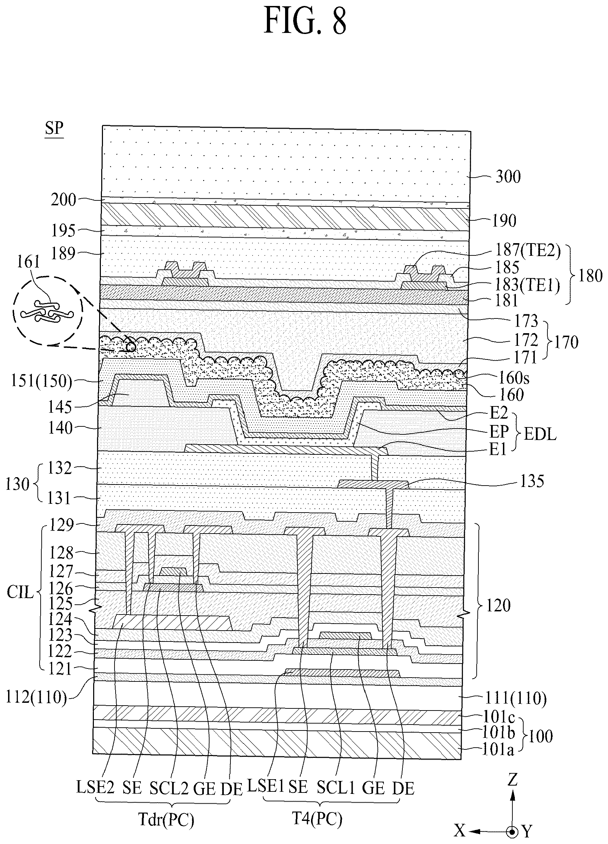

FIG. 8 is another cross-sectional view illustrating an example of a structure of one sub-pixel illustrated in FIGS. 1 and 2. FIG. 8 representatively illustrates a fourth thin-film transistor T4 which is an LTPS transistor, and a driving thin-film transistor Tdr which is an oxide transistor in a sub-pixel. FIG. 8 illustrates an embodiment where a functional interlayer is additionally configured in the light emitting display apparatus (or display panel or sub-pixel) described above with reference to FIGS. 1 to 7. In the following description, therefore, only the functional interlayer and relevant elements will be described, the other elements may be referred to by the same reference numerals as shown in FIGS. 1 to 7, and their repetitive descriptions are omitted. Therefore, the descriptions of FIGS. 1 to 7 may be included in the descriptions of FIG. 8.

Referring to FIG. 8, the light emitting display apparatus (or display panel 10 or sub-pixel SP) according to another embodiment of the present disclosure may further include a functional interlayer 150.

The functional interlayer 150 according to an embodiment may be disposed (or interposed) between the light emitting device layer EDL and the scattering layer 160. For example, the functional interlayer 150 may be disposed (or interposed) between the second electrode E2 of the light emitting device layer EDL and the scattering layer 160.

The functional interlayer 150 may be configured (or disposed) to improve one or more of micro-cavity characteristics, light extraction characteristics, and front viewing angle characteristics of light emitted from the light emitting device layer EDL. The functional interlayer 150 may contact (or directly contact) the surface of the second electrode E2 of the light emitting device layer EDL.

The functional interlayer 150 according to an embodiment may be a capping layer 151 or may include a capping layer 151.

The capping layer 151 may be made of an organic material. The capping layer 151 may be made of an organic material different from that of the scattering layer 160. The capping layer 151 may contact (or directly contact) the surface of the second electrode E2 of the light emitting device layer EDL.

According to an embodiment, since the organic molecules of the capping layer 151 are rigid and have a large molecular weight, there is no self-rotation phenomenon (where energetically favored conformations require that the planes of phenyl substituents do not include each other or backbone portions of the molecule), so it may be formed in a flat structure due to an intermolecular stack structure. Accordingly, for stable deposition of the scattering layer 160 formed on the capping layer 151, the capping layer 151 may have a surface energy of a level similar to that of AgMg material that has been treated by an oxygen plasma process. The capping layer 151 may include a surface-modified layer (or a surface modification layer) having roughness (or surface roughness) resulting from surface treatment by the oxygen plasma process described above with reference to FIG. 4. For example, the oxygen plasma process for the capping layer 151 may be performed for tens of seconds (for example, 40 seconds) or more.

The scattering layer 160 is disposed (or configured) on the functional interlayer 150 and may directly contact a surface of the functional interlayer 150. For example, the scattering layer 160 is disposed (or configured) on the capping layer 151 and may directly contact the surface (or surface-modified layer) of the capping layer 151. The scattering layer 160 is formed on the capping layer 151 of the functional interlayer 150, capping layer 151 being surface-treated by oxygen plasma, and thus, the scattering layer 160 may be stably deposited on (or at) the capping layer 151 of the functional interlayer 150, capping layer 151 having high surface energy imparted by the oxygen plasma process. Accordingly, the scattering layer 160 may be formed (or deposited) to have a light scattering surface 160s on the capping layer 151 of the functional interlayer 150.

As described above, the light emitting display apparatus (or display panel 10) according to another embodiment of the present disclosure includes the functional interlayer 150 (or the capping layer 151) and the scattering layer 160 having the light scattering surface 160s, whereby scattering characteristics of light emitted from the light emitting device layer EDL may be further increased by the scattering layer 160, and due to this, luminance viewing angle characteristics and light extraction amount of the plurality of sub-pixels SP or the display panel 10 may be further increased (or improved).

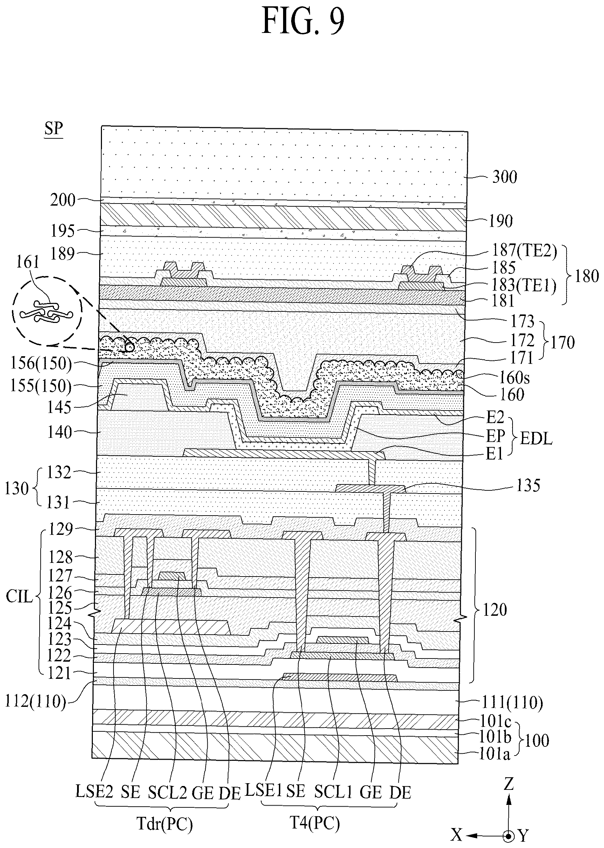

FIG. 9 is another cross-sectional view illustrating an example of a structure of one sub-pixel illustrated in FIGS. 1 and 2. FIG. 9 representatively illustrates a fourth thin-film transistor T4 which is an LTPS transistor, and a driving thin-film transistor Tdr, which is an oxide transistor in a sub-pixel. FIG. 9 illustrates an embodiment implemented by modifying the functional interlayer in the light emitting display apparatus (or display panel or sub-pixel) described above with reference to FIG. 8. In the following description, therefore, only the functional interlayer and relevant elements will be described, the other elements may be referred to by the same reference numerals as shown in FIG. 8, and their repetitive descriptions are omitted. Therefore, the descriptions of FIG. 8 may be included in the descriptions of FIG. 9.

Referring to FIG. 9, in the light emitting display apparatus (or display panel 10 or sub-pixel SP) according to another embodiment of the present disclosure, the functional interlayer 150 may include a first capping layer 155 and a second capping layer 156.

The first capping layer 155 and the second capping layer 156 may be configured (or disposed) to improve one or more of micro-cavity characteristics, light extraction characteristics, and front viewing angle characteristics of light emitted from the light emitting device layer EDL.

The first capping layer 155 and the second capping layer 156 may be configured (or formed) to have different refractive indices.

The first capping layer 155 may contact (or directly contact) a surface of the light emitting device layer EDL. The first capping layer 155 may contact (or directly contact) a surface of the second electrode E2 of the light emitting device layer EDL.

The first capping layer 155 may be made of an organic material. The first capping layer 155 may be made of an organic material different from that of the scattering layer 160. For example, the first capping layer 155 may be made of a same organic material as the capping layer 151 is made from, as described above with reference to FIG. 8. For example, the first capping layer 155 may be a capping layer.

The second capping layer 156 may be configured (or formed) on the first capping layer 155. The second capping layer 156 may be configured (or formed) to entirely cover the first capping layer 155. The second capping layer 156 may contact (or directly contact) a surface of the first capping layer 155.

The second capping layer 156 may be made of a material different from each of the scattering layer 160, the first capping layer 155, and the first encapsulation layer 171. The second capping layer 156 may be made of an inorganic material. For example, the second capping layer 156 may be made of a material having a lower refractive index than the first capping layer 155. For example, the second capping layer 156 may include one or more of LiF (lithium fluoride), MgF₂ (magnesium fluoride), AlF₃ (aluminum fluoride), NaF (sodium fluoride), and AlOₓ (aluminum oxide). For example, the second capping layer 156 may be LiF. For example, the second capping layer 156 may include only LiF. For example, the second capping layer 156 may be AlOₓ (for example, x is 1 to 5).

The second capping layer 156 may function as a metal protection layer preventing oxidation of the second electrode E2 or as an optical correction layer for improving light extraction, but is not limited thereto. For example, the second capping layer 156 may be a metal protection layer or an optical correction layer.

The second capping layer 156 may have a surface energy of a level similar to that of AgMg material modified by an oxygen plasma process. The second capping layer 156 may include a surface-modified layer (or a surface modification layer) having roughness (or surface roughness) as a result of surface treatment by the oxygen plasma process described above with reference to FIG. 4. For example, the oxygen plasma process for the second capping layer 156 may be performed for tens of seconds (for example, 40 seconds) or more. For example, since the first capping layer 155 is covered by the second capping layer 156, the oxygen plasma process for the first capping layer 155 may be omitted.

The scattering layer 160 is disposed (or configured) on the functional interlayer 150 and may directly contact a surface of the functional interlayer 150. For example, the scattering layer 160 is disposed (or configured) on the second capping layer 156 and may directly contact a surface (or surface-modified layer) of the second capping layer 156. Accordingly, the second capping layer 156 may be disposed (or interposed) between the first capping layer 155 and the scattering layer 160. The scattering layer 160 is formed on the second capping layer 156 of the functional interlayer 150, capping layer 156 being surface-treated by oxygen plasma, and thus, the scattering layer 160 may be stably deposited on (or at) the second capping layer 156 of the functional interlayer 150, capping layer 156 having high surface energy by the oxygen plasma process. Therefore, the scattering layer 160 may be formed (or deposited) to have the light scattering surface 160s on (or at) the second capping layer 156 of the functional interlayer 150.

As described above, the light emitting display apparatus (or display panel 10) according to another embodiment of the present disclosure includes the functional interlayer 150 (or the first and second capping layers 155 and 156) and the scattering layer 160 having the light scattering surface 160s, whereby scattering characteristics of light emitted from the light emitting device layer EDL may be further increased by the scattering layer 160, and due to this, luminance viewing angle characteristics and light extraction amount of the plurality of sub-pixels SP or the display panel 10 may be further increased (or improved).

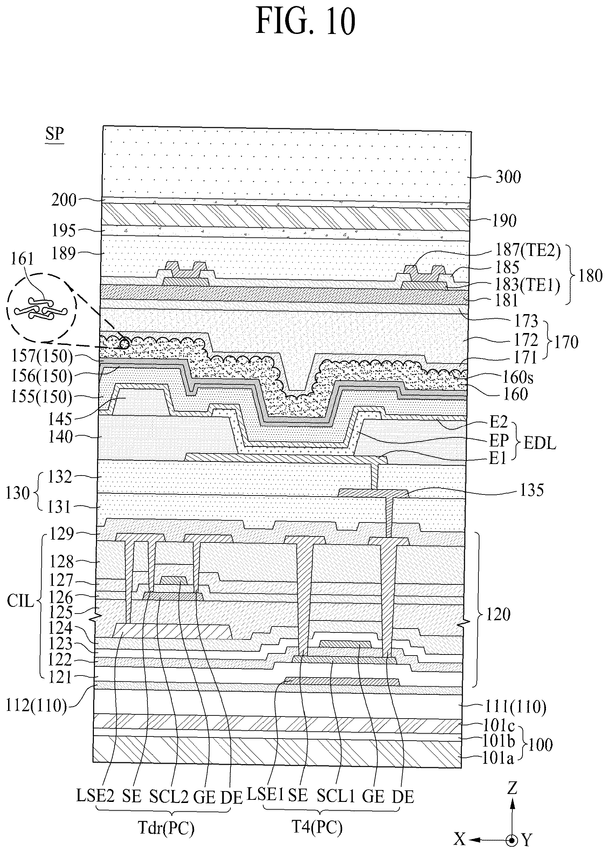

FIG. 10 is another cross-sectional view illustrating an example of a structure of one sub-pixel illustrated in FIGS. 1 and 2. FIG. 10 representatively illustrates a fourth thin-film transistor T4 which is an LTPS transistor, and a driving thin-film transistor Tdr, which is an oxide transistor in a sub-pixel. FIG. 10 illustrates an embodiment implemented by modifying the functional interlayer in the light emitting display apparatus (or display panel or sub-pixel) described above with reference to FIG. 9. In the following description, therefore, only the functional interlayer and relevant elements will be described, the other elements may be referred to by the same reference numerals as shown in FIG. 9, and their repetitive descriptions are omitted. Therefore, the descriptions of FIG. 9 may be included in the descriptions of FIG. 10.

Referring to FIG. 10, in the light emitting display apparatus (or display panel 10 or sub-pixel SP) according to another embodiment of the present disclosure, the functional interlayer 150 may further include a third capping layer 157.

The third capping layer 157 may be configured (or formed) on (or at) the second capping layer 156. The third capping layer 157 may be configured (or formed) to entirely cover the second capping layer 156. The third capping layer 157 may contact (or directly contact) a surface of the second capping layer 156.

The third capping layer 157 may be made of a material different from the second capping layer 156. The third capping layer 157 may be made of an inorganic material. The third capping layer 157 may be made of an inorganic material different from the material of the second capping layer 156. For example, the third capping layer 157 may be made of AgYb.

The third capping layer 157 may form a composite second electrode structure together with the second capping layer 156, and through this, sheet resistance of the second electrode E2 may be reduced. For example, the third capping layer 157 may function as a metal protection layer preventing oxidation of the second electrode E2 or as a conductor dispersing current, but is not limited thereto. Furthermore, a work function of the second electrode E2 may be lowered by a stacked structure of the second capping layer 156 and the third capping layer 157. For example, the third capping layer 157 may be an auxiliary electrode, a semi-transparent auxiliary electrode, an electron injection auxiliary electrode, a current dispersion auxiliary electrode, or an adhesive force reinforcing layer.

The third capping layer 157 may have a surface energy of a level similar to that of AgMg material modified by an oxygen plasma process. The third capping layer 157 may include a surface-modified layer (or a surface modification layer) having roughness (or surface roughness) resulting from surface treatment by the oxygen plasma process described above with reference to FIG. 4. For example, the oxygen plasma process for the third capping layer 157 may be performed for tens of seconds (for example, 40 seconds) or more. For example, since the second capping layer 156 is covered by the third capping layer 157, the oxygen plasma process for the second capping layer 156 may be omitted.

The scattering layer 160 is disposed (or configured) on (or at) the functional interlayer 150 and may directly contact the surface of the functional interlayer 150. For example, the scattering layer 160 is disposed (or configured) on (or at) the third capping layer 157 and may directly contact a surface (or surface-modified layer) of the third capping layer 157. The scattering layer 160 is formed on (or at) the third capping layer 157 of the functional interlayer 150, which has been surface-treated by oxygen plasma, and thus, the scattering layer 160 may be stably deposited on (or at) the third capping layer 157 of the functional interlayer 150, capping layer 157 having high surface energy by the oxygen plasma process. Accordingly, the scattering layer 160 may be formed (or deposited) to have a light scattering surface 160s on (or at) the third capping layer 157 of the functional interlayer 150.

As described above, the light emitting display apparatus (or display panel 10) according to another embodiment of the present disclosure includes the functional interlayer 150 (or the first to third capping layers 155, 156, and 157) and the scattering layer 160 having the light scattering surface 160s, whereby scattering characteristics of light emitted from the light emitting device layer EDL may be further increased by the scattering layer 160, and, due to this, luminance viewing angle characteristics and light extraction amount of the plurality of sub-pixels SP or the display panel 10 may be further increased (or improved).

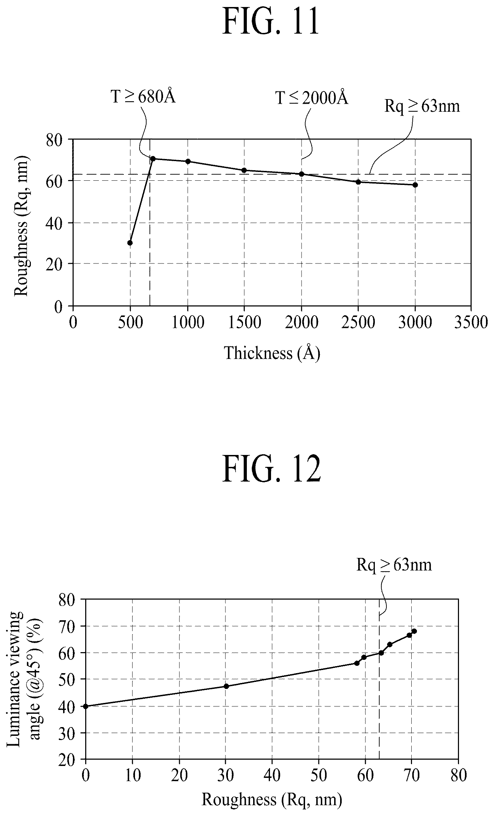

FIG. 11 is a plot illustrating a roughness of a light scattering surface as a function of thickness of a scattering layer in the light emitting display apparatus according to an embodiment of the present disclosure. FIG. 12 is a plot illustrating luminance viewing angles as a function of roughness of a scattering layer in the light emitting display apparatus according to an embodiment of the present disclosure.

Referring to FIGS. 11 and 12, according to an embodiment of the present disclosure, the roughness (for example, root mean square roughness Rq) of the light scattering surface increases as the thickness T of the scattering layer decreases, and due to this, the sizes of a plurality of curved shapes formed on the light scattering surface also increase. However, as the thickness T of the scattering layer decreases to less than 500 Å, the roughness Rq of the light scattering surface sharply decreases, and due to this, the plurality of curved shapes formed on the light scattering surface also sharply become smaller. For example, since deposition power sharply decreases from when the thickness T of the scattering layer is less than 500 Å, the surface roughness of the scattering layer may not be formed or may be fine, so a light scattering effect cannot be expected.

According to an embodiment, with reference to a luminance viewing angle of 45 degrees for the light emitting display apparatus, in order to implement a luminance viewing angle of 70% or more for white W, since the luminance viewing angle for green G should be 60% or more, the roughness Rq for the light scattering surface 160s of the scattering layer 160 should be 63 nm or more, and to satisfy this, the thickness T of the scattering layer may be 680 Å to 2,000 Å. Therefore, the thickness T of the scattering layer for improving the luminance viewing angle by 70% or more may be 680 Å or more and 2,000 Å or less.

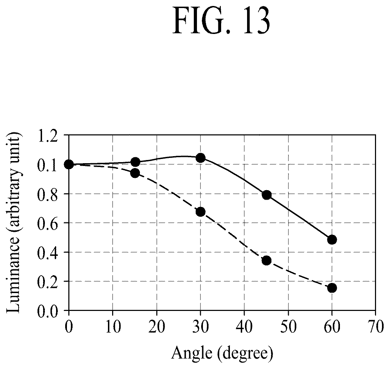

FIG. 13 is a view illustrating luminance with respect to viewing angles of the light emitting display apparatus according to an embodiment of the present disclosure and luminance with respect to viewing angles of a light emitting display apparatus according to an experimental example. In FIG. 13, a dotted line represents the luminance with respect to the viewing angle of the light emitting display apparatus according to an experimental example not including the scattering layer, and a solid line represents the luminance with respect to the viewing angle of the light emitting display apparatus including the scattering layer described above with reference to FIG. 4.

In FIG. 13, since the light emitting display apparatus according to the experimental example does not include the scattering layer, an upper portion of the second electrode of the light emitting device layer has a flat structure. In FIG. 13, in the light emitting display apparatus according to the embodiment of the present disclosure, the scattering layer is disposed on (or at) the second electrode made of AgMg, the thickness of the scattering layer is 1000 Å, and the roughness Rq for the light scattering surface 160s of the scattering layer 160 is 70 nm.

Referring to FIG. 13, with reference to a luminance viewing angle of 45 degrees for the light emitting display apparatus, it may be seen that the luminance of the dotted line is approximately 0.35 (arbitrary unit) and the luminance of the solid line is approximately 0.8 (arbitrary unit). Accordingly, it may be confirmed that the luminance of a light emitting display device including a scattering layer (solid line) is greatly improved compared to the luminance of the experimental example that lacks a scattering layer (dotted line).

With reference to a luminance viewing angle of 60 degrees for the light emitting display apparatus, it may be seen that the luminance of the dotted line is approximately 0.16 (arbitrary unit) and the luminance of the solid line is approximately 0.49 (arbitrary unit). Accordingly, it may be confirmed that the luminance of a light emitting display device including a scattering layer (solid line) is greatly improved compared to the luminance of the experimental example that lacks a scattering layer (dotted line).

With reference to a luminance viewing angle of 45 degrees for the light emitting display apparatus, the luminance viewing angle may be 40% or more. For example, with reference to the front of the light emitting display apparatus, the luminance viewing angle at 45 degrees for light emitted from the light emitting device layer may be 40% or more.

Therefore, the light emitting display apparatus according to an embodiment of the present disclosure includes the scattering layer having the light scattering surface, whereby luminance viewing angle characteristics and light extraction amount may be increased (or improved), and power consumption may be reduced due to low-power driving based on an increase in the amount of light extraction.

The light emitting display apparatus according to embodiments of the present disclosure described above may be applied to mobile devices, video phones, smartwatches, watchphones, wearable devices, foldable devices, rollable devices, bendable devices, flexible devices, curved devices, electronic notebooks, electronic books, portable multimedia players (PMPs), personal digital assistants (PDAs), MP3 players, mobile medical devices, desktop personal computers (PCs), laptop PCs, netbook computers, workstations, navigation systems, automotive navigation systems, automotive display devices, televisions, wallpaper display devices, signage devices, game devices, notebooks, monitors, cameras, camcorders, and home appliances, and the like.

One or more embodiments of the present disclosure may provide a light emitting display apparatus in which a luminance viewing angle characteristic may be enhanced.

One or more embodiments of the present disclosure may provide a light emitting display apparatus in which a luminance viewing angle characteristic and the amount of light extraction may be increased.

One or more embodiments of the present disclosure may provide a light emitting display apparatus in which power consumption may be reduced according to low-power driving based on an increase in the amount of light extraction. Accordingly, the light emitting display apparatus according to one or more embodiments of the present disclosure may implement ESG (environment, social, and governance) performance, based on the effect of reducing power consumption.

## Claims

1. A light emitting display apparatus comprising:
a light emitting device layer (EDL) configured on a substrate (100) and including a first electrode (E1), an emission part (EP), and a second electrode (E2);
a scattering layer (160) configured on the second electrode (E2); and
a protective layer (170) configured on the scattering layer (160).

2. The light emitting display apparatus of claim 1, wherein the scattering layer (160) is made of a material capable of having unevenness or irregular unevenness due to an intermolecular stack structure.

3. The light emitting display apparatus of claim 2, wherein each molecule of the scattering layer (160) has a diameter of 10 Å to 25 Å, and/or
wherein the scattering layer (160) is made of an organic material.

4. The light emitting display apparatus of any of claims 1 to 3, wherein the scattering layer (160) includes a light scattering surface (160s).

5. The light emitting display apparatus of any of claims 1 to 4, wherein the scattering layer (160) includes a tetraphenylethylene-based molecular structure,
wherein, preferably, a molecular weight of the scattering layer (160) is 500 or less.

6. The light emitting display apparatus of any of claims 1 to 5,
wherein:
the scattering layer (160) is made of an organic material including a plurality of aromatic rings and a double bond structure, and
two or more of the plurality of aromatic rings are in a rotated conformation such that the double bond structure is not coplanar with the aromatic rings;
and/or wherein:
the scattering layer (160) comprises one of bathocuproine, triphenylamine derivatives, bathophenanthroline, perylene derivatives, and pentacene derivatives.

7. The light emitting display apparatus of any one of claims 1 to 6, wherein the scattering layer (160) has a thickness of 500 Å to 3000 Å, and/or
wherein a surface roughness of a light scattering surface (160s) of the scattering layer (160) is 10 nm or more.

8. The light emitting display apparatus of any one of claims 1 to 7,
wherein the second electrode (E2) is made of a transparent conductive oxide or an alloy material of silver and magnesium, and
wherein the second electrode (E2) made of the transparent conductive oxide includes a surface-modified layer surface-treated by oxygen plasma.

9. The light emitting display apparatus of any one of claims 1 to 8, further comprising a functional intermediate layer (150) disposed between the second electrode (E2) and the scattering layer (160).

10. The light emitting display apparatus of claim 9,
wherein the functional intermediate layer (150) includes a capping layer (151) made of an organic material, and
wherein the capping layer (151) includes a surface-modified layer surface-treated by oxygen plasma.

11. The light emitting display apparatus of claim 9,
wherein the functional intermediate layer (150) includes a first capping layer (155) and a second capping layer (156) having different refractive indices,
wherein the first capping layer (155) is in contact with the second electrode (E2), and
wherein the second capping layer (156) is disposed between the first capping layer (155) and the scattering layer (160) and includes one of LiF, MgF₂, AlF₃, NaF, and AlOₓ.

12. The light emitting display apparatus of claim 11, wherein the second capping layer (156) which is in contact with the scattering layer (160) includes a surface-modified layer surface-treated by oxygen plasma.

13. The light emitting display apparatus of claim 11,
wherein the functional intermediate layer (150) further includes a third capping layer (157) on the second capping layer (156), and
wherein the scattering layer (160) is on the third capping layer (157).

14. The light emitting display apparatus of claim 13, wherein the third capping layer (157) includes AgYb, and/or
wherein the third capping layer which is in contact with the scattering layer (160) includes a surface-modified layer surface-treated by oxygen plasma.

15. The light emitting display apparatus of any one of claims 1 to 14, wherein the emission part (EP) includes one or more emission layers between the first electrode (E1) and the second electrode (E2).
